# EUROPÄISCHE PATENTANMELDUNG

(11) **EP 1 575 171 A1**
(43) Veröffentlichungstag der Anmeldung: **14.09.2005**
(21) Anmeldenummer: 05003802.5
(22) Anmeldetag: 22.02.2005
(51) Int. Cl.: H03M 1/82

(54) **Digital-Analog-Wandlung mit verschachteltem pulsweitenmodulierten Signal**

(30) Priorität: 10.03.2004 DE 102004011723
(71) Anmelder: Patent-Treuhand-Gesellschaft für elektrische Glühlampen mbH, 81543 München (DE)
(72) Erfinder: Schallmoser, Oskar, 85521 Ottobrunn (DE)

(57) **Zusammenfassung**

Die Erfindung bezieht sich auf ein Verfahren und eine Schaltung zur Digital-Analog-Wandlung, bei dem/der ein verschachteltes Pulsweitenmodulationssignal (VPWM) tiefpassgefiltert wird.

## Beschreibung

### Technisches Gebiet

Die vorliegende Erfindung betrifft ein Verfahren und eine Schaltung zur Digital-Analog-Wandlung.

### Stand der Technik

Die Umwandlung digitaler Signale in analoge Signale ist ein häufiges Problem in verschiedenen Gebieten der Elektronik. Neben verschiedenen anderen Verfahren ist u.a. die Tiefpassfilterung eines pulsweitenmodulierten Signals bekannt. Bei dem pulsweitenmodulierten Signal stellt die Dauer eines bestimmten logischen Pegels für sich betrachtet oder auch als sogenanntes Tastverhältnis in Relation zu der Dauer des anderen logischen Pegels die zu übertragende Information dar. Wenn nun eine zeitliche Mittelwertbildung durch eine Tiefpassfilterung vorgenommen wird, so stellt sich mit dem Mittelwert ein analoges Signal ein, dass der zeitlichen Dauer des logischen Pegels bzw. dem Tastverhältnis kontinuierlich folgt.

### Darstellung der Erfindung

Der Erfindung liegt das technische Problem zugrunde, ein neues Verfahren und eine neue Schaltung zur Digital-Analog-Wandlung mit günstigen Eigenschaften anzugeben.

Die Erfindung richtet sich zum einen auf Verfahren zur Digital-Analog-Wandlung, bei dem aus einem digitalen Signal ein verschachteltes pulsweitenmoduliertes Signal erzeugt wird und das verschachtelte pulsweitenmodulierte Signal mit einem Filter mit Tiefpasscharakteristik gefiltert wird, wobei das verschachtelte pulsweitenmodulierte Signal bei zumindest einem Teil der Werte des digitalen Signals innerhalb einer Musterwiederholzeit zumindest zwei Zeitunterblöcke mit einem bestimmten logischen Zustand und zumindest zwei weitere Zeitunterblöcke mit einem anderen bestimmten logischen Zustand enthält und die Summe der Pulsweiten der Zeitunterblöcke den digitalen Wert darstellt,
sowie auf eine entsprechend ausgestattete Schaltung mit einer Einrichtung zum Erzeugen des verschachtelten pulsweitenmodulierten Signals aus dem digitalen Signal und einem Tiefpassfilter zum Filtern des verschachtelten pulsweitenmodulierten Signals, welche Einrichtung für das erfindungsgemäße Verfahren ausgelegt ist.

Bevorzugte Ausgestaltungen sind in den abhängigen Ansprüchen angegeben.

In der folgenden Beschreibung wird nicht mehr ausdrücklich zwischen dem Verfahrenscharakter und dem Vorrichtungscharakter der Erfindung unterschieden, so dass die Offenbarung einschließlich des Ausführungsbeispiels im Hinblick auf beide Kategorien zu verstehen ist.

Die Erfindung betrifft damit eine Digital-Analog-Wandlung durch Tiefpassfilterung eines Signals, das hier als verschachteltes pulsweitenmoduliertes Signal bezeichnet wird. Damit soll ausgedrückt werden, dass das Signal im Unterschied zu einem konventionellen pulsweitenmodulierten Signal innerhalb einer Musterwiederholzeit mehr als einen Zeitunterblock mit einem jeweiligen logischen Zustand enthält. Vielmehr soll das erfindungsgemäße verschachtelte pulsweitenmodulierte Signal innerhalb der Musterwiederholzeit durch eine Mehrzahl von Zeitunterblöcken verschachtelt sein. Unter einer Musterwiederholzeit wird dabei ausgehend von einem gleichbleibenden, aber beliebigen Wert des zu wandelnden Digitalsignals die minimale Zeit verstanden, mit der sich das Signalmuster des verschachtelten pulsweitenmodulierten Signals wiederholt. Zu beachten ist dabei, dass sich die Musterwiederholzeit nicht auf für ganz bestimmte (und nicht für beliebige) Werte des digitalen Signals auftretende kleine Zeiteinheiten innerhalb der Verschachtelung bezieht, mit denen sich ein symmetriebedingtes Muster wiederholt. Solche Symmetrien können werteabhängig vorkommen. Die Musterwiederholzeit ist vielmehr die Zeit, die tatsächlich den digitalen Wert wiedergibt, also diejenige Zeit, mit der sich das Signal auch bei nicht-symmetrischen Verschachtelungsmustern wiederholt.

Bei dem erfindungsgemäßen verschachtelten Pulsweitenmodulationssignal tritt also eine Mehrzahl von Zeitunterblöcken mit bestimmten logischen Zuständen auf, so dass es im Gegensatz zu einem konventionellen Pulsweitenmodulationssignal zu einer entsprechend erhöhten Zahl von Signalzustandswechseln kommt.

Zur näheren Veranschaulichung wird die Erfindung anhand einer bevorzugten Ausführungsform erläutert, bei der ein konventionelles pulsweitenmoduliertes Signal in ein erfindungsgemäßes verschachteltes Pulsweitenmodulationssignal umgeformt wird. Obwohl dies ein Spezialfall ist, ist er wegen des Vergleichs beider Signale auch für das Verständnis des verschachtelten pulsweitenmodulierten Signals an sich illustrativ.

Die Grundidee der Erfindung besteht hier also darin, das pulsweitenmodulierte Signal so umzuformen, dass durch eine zeitliche Unterteilung Zeitunterblöcke geschaffen werden, die in einer gegenüber der ursprünglichen Unterteilung abweichenden Reihenfolge angeordnet werden. Dabei wird eine Musterwiederholzeit des pulsweitenmodulierten Signals betrachtet, im Fall eines Signals mit fester Frequenz beispielsweise einer Periode. Die Musterwiederholzeit muss mindestens einen Zeitblock mit logisch positivem Zustand und einen angrenzenden Zeitblock mit logisch negativem Zustand enthalten, könnte jedoch auch weitere Zeitblöcke enthalten. Die zeitliche Unterteilung soll dabei Zeitunterblöcke schaffen, die jeweils einen eindeutigen logischen Zustand, also einen positiven oder einen negativen Zustand, aufweisen. Insbesondere soll also die Grenze zwischen dem logisch positiven Zeitblock und dem logisch negativen Zeitblock in der Musterwiederholzeit auch nach der Unterteilung wieder einer Grenze zwischen Zeitunterblöcken entsprechen.

Die Umordnung soll in solcher Weise erfolgen, dass die Anzahl von logischen Zustandswechseln innerhalb der Musterwiederholzeit erhöht wird. Wenn man also beispielsweise von einer Musterwiederholzeit mit genau einem logisch positiven Zeitblock und genau einem logisch negativen Zeitblock ausgeht, so entfallen auf diese Musterwiederholzeit im ursprünglichen Zustand zwei logische Zustandswechsel. Wenn jedoch die Zeitunterblöcke neu verteilt werden, so werden in vielen Fällen mehr als zwei logische Zustandswechsel innerhalb der Musterwiederholzeit auftreten. Im erfindungsgemäß bevorzugten Fall wird die Anzahl der logischen Zustandswechsel bei vorgegebener Unterteilung in Zeitunterblöcke maximiert. Eine feinere Unterteilung erlaubt natürlich eine Maximierung zu einer noch größeren Zahl von Zustandswechseln.

Die reine Umordnung der Zeitunterblöcke bei gleichbleibenden logischen Werten der jeweiligen Unterblöcke verändert den Mittelwert des Signals, der durch die Tiefpassfilterung als Analogwert gewonnen wird, nicht. Durch die Umordnung kann jedoch eine stärkere Betonung von höher frequenten Frequenzkomponenten erzielt werden und damit eine bessere Filterbarkeit des Signals durch das Tiefpassfilter erzielt werden. Wenn man sich zur Veranschaulichung einen Tiefpassfilter in der Form eines üblichen RC-Gliedes vorstellt, so sind in Folge der erfindungsgemäßen Umordnung der Zeitunterblöcke die Zeitabstände zwischen den Zustandswechseln kürzer, so dass in dem Filterkondensator Umladevorgänge mit kleineren Spannungsamplituden auftreten. Das gefilterte Signal hat damit eine Rauhigkeit ("ripple") mit geringerer Amplitude und ist damit besser gefiltert. Es können in anderen Worten einfachere Filter verwendet werden, etwa solche mit kleineren Kondensatoren. Eine andere Möglichkeit, die hier nach vorrangigen Interessen bei der Schaltungsauslegung im Vordergrund stehen kann oder auch gleichzeitig relevant sein kann, ist die Möglichkeit kleinerer Ausgangsimpedanzen und damit geringerer Verschiebungen in Folge schwankender Ausgangsströme.

Bei der Erfindung geht also darum, die durch die Unterteilung in einem konventionellen pulsweitenmodulierten Signal oder in einem anderweitig erzeugten erfindungsgemäßen Signal definierten Zeitunterblöcke über die Musterwiederholzeit so zu verteilen, dass kleinere Zeitabstände zwischen den Zustandswechseln auftauchen. Diese Aussage gilt natürlich abhängig von dem dargestellten Wert. Insbesondere bei Werten ganz am Rand des darstellbaren Wertebereichs kann es dazu kommen, dass der Zeitblock mit dem logisch positiven oder negativen Zustand nur noch einem einzigen Zeitunterblock entspricht und damit für diesen einen bzw. für die beiden äußersten Werte des darstellbaren Wertebereichs durch eine Umordnung keine Erhöhung der Zahl der Zustandswechsel erzielt werden kann. Im Prinzip könnten ähnliche Ausnahmen auch in Abhängigkeit vom Umordnungsschema für andere Werte auftreten. Wesentlich ist jedoch, dass gewissermaßen ein Mittel über alle auftretenden Werte insgesamt eine Erhöhung der Zustandswechselzahl und damit auch eine Verringerung der zeitlichen Abstände erzielt wird.

Vorzugsweise soll sogar eine gewisse Gleichverteilung der Zeitunterblöcke mit bestimmten logischen Zustand angestrebt werden, also der logisch positiven innerhalb der logisch negativen oder umgekehrt. Allerdings wäre eine echte Gleichverteilung innerhalb der Musterwiederholzeit zwar vorteilhaft im Hinblick auf die Filterbarkeit, jedoch unter Umständen hinsichtlich der notwendigen Umverteilungsvorgänge komplizierter als andere Schemata, die nur eine Annäherung an eine Gleichverteilung erzielen. Daher sieht die Erfindung bereits solche Umverteilungen als besonders günstig an, bei denen zumindest in etwa der Hälfte der Musterwiederholzeit eine Gleichverteilung von Zeitunterblöcken erzielt wird. (Um Missverständnissen vorzubeugen: Es soll keine Gleichverteilung im Sinne von gleichviel logisch negativen und logisch positiven Zeitunterblöcken erzielt werden sondern eine gleichmäßige Verteilung der Zeitunterblöcke mit dem selteneren logischen Wert innerhalb des Rests.)

Oben wurde bereits ausgeführt, dass die Umwandlung eines konventionellen Pulsweitenmodulationssignals nur eine Möglichkeit zur Ausführung des erfindungsgemäßen Verfahrens darstellt. Es ist auch möglich, ein erfindungsgemäß verschachteltes Pulsweitenmodulationssignal auf der Basis eines anderen digitalen Signals zu erzeugen. Eine bevorzugte Vorgehensweise geht dabei davon aus, die Signalwerte des zu wandelnden digitalen Signals mit einem Signal zu vergleichen, das durch eine Bitvertauschung eines Zählersignals gewonnen wird. Konventionelle pulsweitenmodulierte Signale können nämlich dadurch erzeugt werden, dass der entsprechende digitale Wert mit einem monoton ansteigenden oder monoton abfallenden Stufensignal, also einem Zählersignal, verglichen wird. Je nachdem, wie hoch der digitale Wert ist, erfolgt der Zustandswechsel früher oder später innerhalb der Musterwiederholzeit. Wenn nun das Zählersignal vor dem Vergleich durch eine Bitvertauschung verändert wird und danach nicht mehr monoton fällt oder steigt, so kann in dieser Weise ein erfindungsgemäßes verschachteltes Pulsweitenmodulationssignal erzeugt werden. Das Vergleichsergebnis unterscheidet sich von dem Vergleichsergebnis beim konventionellen Pulsweitenmodulationssignal nur durch eine Umordnung innerhalb der Musterwiederholzeit. Eine Mittelwertsbildung durch nachfolgende Tiefpassfilterung ist davon nicht betroffen.

Besonders bevorzugt ist eine Bitvertauschung des Zählersignals, bei der (zumindest) das am wenigsten signifikante Bit (LSB) an die Stelle des am meisten signifikanten Bits (MSB) gesetzt wird. Ein bevorzugter Sonderfall sieht vor, dass die Bitreihenfolge insgesamt invertiert wird, das signifikanteste Bit also an die Stelle des am wenigsten signifikanten Bits gesetzt wird, das zweitsignifikanteste an die Stelle des am zweitwenigsten signifikanten Bits usw. So entstehen in einer technisch einfachen Weise in hohem Maße verschachtelte Pulsweitenmodulationssignale, ohne dass ein eigentliches konventionelles Pulsweitenmodulationssignal umverteilt wird. Bei dieser Ausführungsform findet die Umverteilung vielmehr bereits in dem Zählersignal vor dem Vergleich statt.

Eine weitere bevorzugte Ausgestaltung sieht vor, dass für die Bitvertauschung, etwa auch für eine Bitinversion gemäß der vorstehenden Erläuterung, eine sog. Look-Up-Tabelle verwendet wird, also ein Speicher, in dem durch die Speichereinträge an den jeweiligen Adressen die Bitvertauschung realisiert ist. In dieser Weise lassen sich auch komplexere Vertauschungsmuster leicht realisieren, wenn einmal die Struktur der Look-Up-Tabelle festgelegt ist. Insbesondere ließe sich so auch eine vollständige Gleichverteilung der Zeitunterblöcke innerhalb der Musterwiederholzeit realisieren.

Die Erfindung betrifft ferner eine Schaltung zur Durchführung des geschilderten Verfahrens, die dementsprechend eine Einrichtung zum Erzeugen des verschachtelten pulsweitenmodulierten Signals aus dem digitalen Signal und ein Tiefpassfilter aufweist. Sie weist ferner in den verschiedenen bevorzugten Ausgestaltungen entsprechende Einrichtungen für die geschilderten Verfahrensschritte auf. Die vorstehende Beschreibung des Verfahrens ist dabei als funktionale Festlegung der Vorrichtungsmerkmale, also der entsprechenden Einrichtungen der Schaltung, aufzufassen.

Das Tiefpassfilter kann unterschiedliche Gestalt haben. Bevorzugt ist im Rahmen dieser Erfindung ein RC-Filter, insbesondere ein RC-Filter zweiter Ordnung.

Vorzugsweise richtet sich die Erfindung auf ein elektronisches Vorschaltgerät für eine Licht emittierende Vorrichtung, insbesondere eine Lampe oder eine LED, in der eine solche Schaltung verbaut ist. Dieses elektronische Vorschaltgerät stellt einen bevorzugten Anwendungsfall dar, obwohl das Verfahren und die Vorrichtung zur Digital-Analog-Wandlung auch in vielen anderen technischen Gebieten Einsatz finden können.

In elektronischen Vorschaltgeräten werden auch Mikrocontroller-Steuerungen eingesetzt. Dabei kann ein Digitalsignal der Mikrocontroller-Steuerung an die eventuell integrierte Einrichtung zur Erzeugung des verschachtelten pulsweitenmodulierten Signals angeschlossen werden, um in dieser Weise schließlich durch Tiefpassfilterung ein Analogsignal zu erzeugen. Insbesondere kann dabei in einer einfachen und effizienten Weise ein Analogsignal als (mittelbares) Ausgangssignal der Mikrocontroller-Steuerung erzeugt werden, wobei durch die Erfindung die bereits geschilderten Vorteile hinsichtlich der Filterbarkeit des Signals und der Anforderungen an das Filter erzielt werden.

Bei der Lampe handelt es sich vorzugsweise um eine Entladungslampe und im Rahmen dieser Erfindung besonders bevorzugter Weise um eine Entladungslampe, die für sog. dielektrisch behinderte Entladungen ausgelegt ist. Solche Entladungslampen benötigen besondere Vorschaltgeräte, die eine gepulste Leistungseinkopplung in die Entladungslampe bewirkten.

### Kurze Beschreibung der Zeichnungen

Im Folgenden wird die Erfindung anhand zweier Ausführungsbeispiele erläutert. Die dabei offenbarten Merkmale können auch in anderen Kombinationen erfindungswesentlich sein und beziehen sich sowohl auf den Verfahrens- als auch auf den Vorrichtungscharakter der Erfindung.

Im Einzelnen zeigt:
- Figur 1: ein schematisches Diagramm eines ersten Ausführungsbeispiels der Erfindung;
- Figur 2: ein schematisches Diagramm eines erfindungsgemäßen elektronischen Vorschaltgeräts, in dem das Ausführungsbeispiel aus Figur 1 eingesetzt wird;
- Figur 3: anhand von Zeitverlaufsdiagrammen die Erzeugung eines pulsweitenmodulierten Signals nach dem Stand der Technik;
- Figur 4: analog zu Figur 3 die Erzeugung eines verschachtelten pulsweitenmodulierten Signals analog dem Ausführungsbeispiel aus Figur 1;
- Figur 5: ein Diagramm mit der absoluten Höhe des Wechselanteils eines tiefpassgefilterten Signals A aus Figur 1 über dem Bytewert;
- Figur 6: einen Ausschnitt aus Figur 5;
- Figur 7: eine schematische Darstellung eines zweiten Ausführungsbeispiels.

### Bevorzugte Ausführung der Erfindung

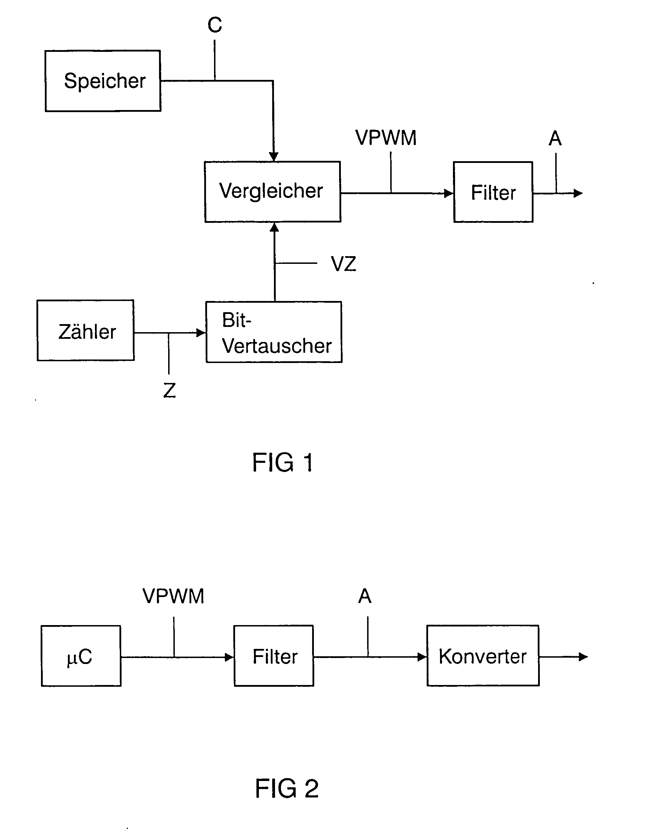

In Figur 1 ist anhand eines Blockdiagramms das Prinzip der Erfindung in einem ersten Ausführungsbeispiel dargestellt. Die im Folgenden anhand von separaten Baueinheiten erläuterten Verfahrensschritte werden bei diesem Ausführungsbeispiel mit Ausnahme des Filters tatsächlich innerhalb eines in Figur 2 gezeigten Mikrocontrollers realisiert.

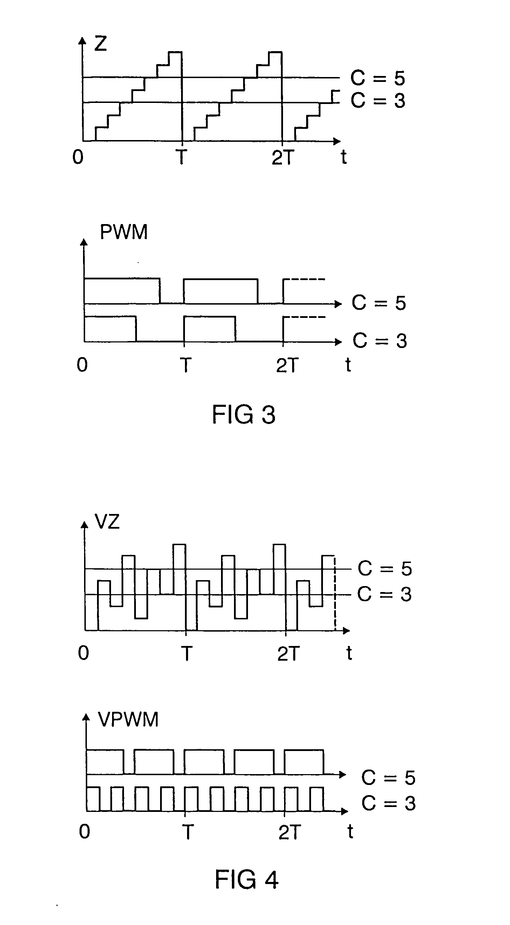

Ein Speicher enthält digitale Werte C als digitales Signal, die in einen Vergleicher eingegeben werden. Dort werden sie mit einem Signal verglichen, das durch Bitvertauschung aus einem Signal Z eines Zählers erzeugt wird. Hierzu wird auf die Erläuterungen der Figuren 3 und 4 verwiesen. Der Vergleicher erzeugt durch den Vergleich zwischen dem digitalen Signal C und dem verschachtelten Zählersignal VZ aus dem Bitvertauscher ein verschachteltes pulsweitenmoduliertes Signal VPWM, das in ein Filter, hier ein RC-Glied zweiter Ordnung, gegeben und dort zu einem Analogsignal A gefiltert wird.

Figur 2 zeigt ebenfalls anhand eines Blockdiagramms ein Ausführungsbeispiel, in dem ein Mikrocontroller, der in der Figur mit µC bezeichnet ist, das verschachtelte pulsweitenmodulierte Signal VPWM aus Figur 1 abgibt. Der Mikrocontroller enthält den Speicher und den Zähler aus Figur 1. Die Bitvertauschung ist in Form einer Look-Up-Tabelle, also ebenfalls als Speicher, realisiert. Der Vergleicher ist softwaretechnisch implementiert.

Der Vergleicher selbst kann ebenfalls in Form einer Look-Up-Tabelle, also in einem Speicher, realisiert sein. Dabei kann man ausnutzen, dass sich bei vielen Anwendungen, etwa im Fall des Stromabschaltwerts in diesem Ausführungsbeispiel, der Wert für C selten, betragsmäßig gering und dabei langsam ändert. Damit ist nicht nur das bitvertauschte Zählersignal VZ sondern bereits das Vergleicher-Ausgangssignal VPWM in einer Look-Up-Tabelle abgelegt, und zwar unter Voraussetzung eines bestimmten Werts für C. Je nach zur Verfügung stehendem Speicherplatz könnten einige benachbarte C-Werte ebenfalls in dieser Look-Up-Tabelle berücksichtigt sein. Da sich die C-Werte in diesem Fall nur langsam ändern können, kann ein im Hintergrund ablaufendes Programm im Bedarfsfall die Look-Up-Tabelle neu beschreiben, um neue C-Werte zu berücksichtigen. Damit kann insgesamt vermieden werden, dass im Betrieb durch die immer wieder auftretenden Vergleichsvorgänge Rechenleistung blockiert wird.

Das verschachtelte Pulsweitenmodulationssignal VPWM durchläuft das Filter aus Figur 1, dessen analoges Ausgangssignal A an einen sog. Klasse-E-Konverter zur Ansteuerung einer dielektrisch behinderten Entladungslampe angelegt wird. Konkret handelt es sich hier um einen Stromabschaltwert eines Wechselrichters in dem Klasse-E-Konverter, der in Form des digitalen Signals C in dem Speicher des Mikrocontrollers abgelegt ist und dem Klasse-E-Konverter als analoges Signal A zugeführt werden muss. Die Erfindung erzeugt also aus einem digitalen Speicherwert der Mikrocontroller-Steuerung des Klasse-E-Konverters ein analoges Signal zur Ansteuerung und ersetzt damit einen Analogausgang des Mikrocontrollers µC.

Figur 3 dient zur Veranschaulichung der Figuren 1 und 4, zeigt jedoch den Stand der Technik. Figur 3 zeigt im oberen Bereich das Zählersignal Z aus Figur 1, nämlich ein monoton stufenweise ansteigendes Signal, über dem Zeitverlauf t. Die horizontalen Striche symbolisieren zwei beispielhafte Werte für den digitalen Wert C und zwar bei 5 und bei 3. Zur Vereinfachung wird hier ein 3 Bit-System mit Werten von 0 bis 7 angenommen. Man erkennt, dass das Signal nach bestimmten Zeiten über den Wert von C hinaus steigt, und zwar bis an das Ende der mit T bezeichneten Musterwiederholzeit. Damit ergibt sich durch einen Vergleicher, dem direkt das Signal Z an Stelle des in Figur 1 eingesetzten bitvertauschten Signals VZ zugeführt wird, der im unteren Bereich der Figur 3 gezeigte Zeitverlauf eines konventionellen pulsweitenmodulierten Signals PWM. Dieses hat innerhalb des Zeitanteils der Musterwiederholzeit T, in dem der Wert C größer als das oder gleich dem Zählersignal Z ist, einen logisch positiven hochpegeligen Zustand und danach einen niederpegeligen Zustand. Dieses Muster wiederholt sich mit der Musterwiederholzeit T und ist für die beiden Beispielswerte 5 und 3 für den Wert von C dargestellt. Man erkennt, dass das konventionelle Pulsweitenmodulationssignal PWM innerhalb der Musterwiederholzeit im Allgemeinen zwei Zustandswechsel aufweist, wobei es bei den Randwerten C = 0 bzw. C = 7 (bei einer 3 Bit-Variante) Ausnahmen geben könnte.

Damit lässt sich das Diagramm in Figur 4 besser verstehen, in dem das erfindungsgemäße Prinzip ebenfalls für einen vereinfachten 3 Bit-Fall dargestellt ist. Hier zeigt der obere Bereich das bitvertauschte Zählersignal VZ, in dem die zugrundeliegende Bit-Reihenfolge vollständig invertiert wurden, also bei diesem Beispiel das erste Bit an die Stelle des dritten Bits und bei einem 8 Bit-System das erste Bit an die Stelle des achten Bits, das zweite Bit an die Stelle des siebten Bits, das dritte Bit an die Stelle des sechsten Bits und umgekehrt gesetzt wurden. Damit ergibt sich der dargestellte nicht monotone Verlauf des bitvertauschten Zählersignals VZ. Man erkennt ferner, dass sich wieder eine Musterwiederholzeit T gleicher Länge wie in Figur 3 festlegen lässt. Das entsprechende Vergleicher-Ausgangssignal VPWM zeigt nun abhängig vom digitalen Wert C eine Mehrzahl Zustandswechsel innerhalb der Musterwiederholzeit T, und zwar beispielsweise vier Zustandswechsel bei C = 5 und acht Zustandswechsel bei C = 3. Diese sind mindestens in der Hälfte der Musterwiederholzeit gleichverteilt. Es ist darauf hinzuweisen, dass es auch Werte für C gibt (und zwar am Rand des Wertebereichs von C), bei denen sich die Zahl der Zustandswechsel nicht erhöht. Man kann sich jedoch bereits veranschaulichen, dass das verschachtelte pulsweitenmodulierte Signal VPWM im Allgemeinen einen gegenüber dem konventionellen pulsweitenmodulierten Signal PWM erhöhten Anteil höherfrequenter Komponenten aufweist bzw. der mittlere Zeitabstand zwischen Zustandswechseln und damit die Umladezeiten beispielsweise in der Kapazität eines RC-Filters kürzer sind.

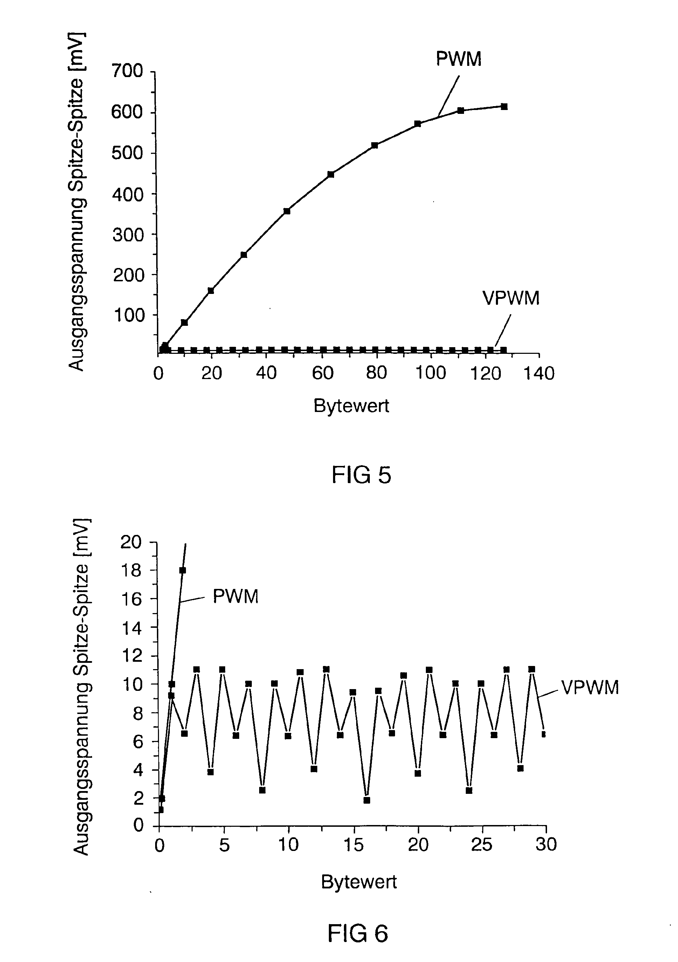

Weitere Vorteile werden anhand der Figuren 5 und 6 erläutert, die sich jedoch auf ein reales 8 Bit-Beispiel beziehen

In Figur 5 zeigt sich die absolute Höhe des Wechselanteils, d. h. der Spitze-Spitze-Wert der Ausgangsspannung (in mV) nach der Tiefpassfilterung gemäß Figur 1, und zwar einerseits unter Voraussetzung der erfindungsgemäßen Vorgehensweise nach Figur 1, die mit VPWM symbolisiert ist, und andererseits unter Voraussetzung der konventionellen Vorgehensweise gemäß Figur 3, bei der also der Bitvertauscher in Figur 1 weggelassen und das Zählersignal Z direkt an den Vergleicher gelegt wird. Der konventionelle Fall ist mit PWM bezeichnet. Anhand Figur 3 kann man sich veranschaulichen, dass bei kleinen C-Werten zunächst zeitlich kurze hochpegelige und zeitlich lange niederpegelige Anteile in dem pulsweitenmodulierten Signal auftreten und damit nur geringe kapazitive Aufladungen erfolgen können. Für hohe C-Werte gilt der umgekehrte Fall. Der in Figur 5 dargestellte Spitze-Spitze-Spannungswert nach Filterung ist demzufolge in Randnähe des Bytewertebereichs, der im vorliegenden 8 Bit-Fall von 0 - 255 reicht, klein. Der Spitze-Spitze-Spannungswert steigt jedoch von beiden Seiten symmetrisch bis zur Mitte des Bytewertebereichs bei C = 127, wo in diesem Fall etwa 620 mV "ripple" erzeugt werden.

In Figur 5 kaum erkennbar und in der Nähe der horizontalen Achse ist der "ripple"-Wert für den erfindungsgemäßen Fall eingezeichnet und mit VPWM bezeichnet. Figur 6 zeigt dieses Diagramm für die ersten 30 Bytewerte als Ausschnitt. Man erkennt, dass sich nur für die ersten Randbytewerte eine Entsprechung zwischen dem konventionellen und dem erfindungsgemäßen Fall zeigt. In diesem Bereich ist jedoch auch im konventionellen Fall kein großer "ripple"-Wert vorhanden. In Folge der in Figur 4 veranschaulichten Verschachtelung des erfindungsgemäßen Pulsweitenmodulationssignals entstehen jedoch bei zunehmenden Bytewerten keine längeren kapazitiven Ladephasen, weil diese durch die Verschachtelung immer wieder unterteilt und verteilt sind. Damit bleibt der "ripple"-Wert für den gesamten Bytewertebereich in einem Bereich unter etwa 12 mV, was gegenüber dem konventionellen Fall einer Verbesserung von bis zu 34 dB entspricht. Hierbei wurden in beiden Fällen identische Tiefpassfilter vorausgesetzt, die hier mit Standard-SMD-Bauteilen realisiert sind. In Folge der deutlich verbesserten analogen Signalqualität könnte man jedoch auch geringere Anforderungen an das Filter stellen, wie bereits zuvor erläutert.

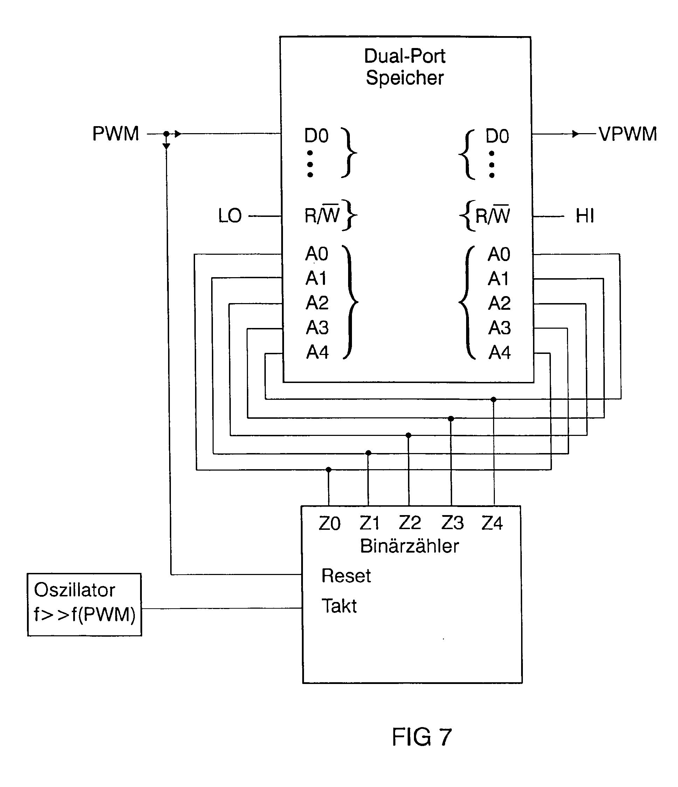

Figur 7 zeigt ein zweites Ausführungsbeispiel der Erfindung. Dort ist ein sogenannter Dual-Port-Speicher eingezeichnet. Ein solcher Dual-Port-Speicher weist voneinander unabhängig arbeitende Adress- und Datenbussysteme auf. Der Dual-Port-Speicher weist Datenanschlüsse D0 und folgende auf, von denen nur D0 eingezeichnet und für dieses Ausführungsbeispiel benötigt wird. Mit weiteren Dateneingängen könnten weitere Signale in der im Folgenden beschriebenen Weise umgeformt werden.

Figur 7 zeigt, dass ein mit PWM bezeichnetes pulsweitenmoduliertes Signal an D0 angelegt wird und auf der rechten Seite an einem weiteren D0-Anschluss ein in der erfindungsgemäßen Weise verschachteltes pulsweitenmoduliertes Signal VPWM abgenommen wird. Dazu liegt ein darunter mit R/W bezeichneter Anschluss links auf Niederpegel (LO) und rechts auf Hochpegel (HI), womit zwischen Schreiben (links) und Lesen (rechts) unterschieden wird.

Das Signal PWM wird zeitlich sequentiell in Speicherplätze geschrieben, die 5 Bit-Adressen mit den Stellen A0 bis A4 aufweisen. Zum Einschreiben werden die Adressen auf der linken Seite eingegeben. Zum Auslesen werden sie rechts eingegeben. Dies erfolgt über einen unten eingezeichneten Binärzähler mit Ausgängen Z0 bis Z4. Mit der ersten steigenden Flanke wird der Binärzähler zurückgesetzt (Reset) und zählt dann über die Ausgänge Z0 bis Z4 die Adressen der Speicherplätze hoch. Dementsprechend wird das PWM-Signal zeitlich sequentiell eingeschrieben.

Figur 7 zeigt, dass die Ausgänge Z0 bis Z4 des Binärzählers in einer bitvertauschten Weise an die Adressenbit-Anschlüsse A0 bis A4 auf der rechten Seite angeschlossen sind. Das Auslesen der Signalwerte aus den Speicherplätzen erfolgt also durch Bit-Vertauschung zeitlich verschachtelt, so dass es zu dem bereits erläuterten verschachtelten Signal VPWM kommt. Dabei wird die Funktion des Binärzählers mit dem gleichen Takt wie der (nicht eingezeichnete) Takt des Dual-Port-Speichers gesteuert. Dieser Takt hat eine erheblich höhere Frequenz f als die des pulsweitenmodulierten Signals PWM (f >> f(PWM)), und zwar in diesem Beispiel genau das 2⁵-fache. Dabei ist die Zahl der Speicherplätze mit den 5 Bit-Adressen zusammen mit dem Takt so abgestimmt, dass eine Periode des Signals PWM sämtliche Speicheradressen belegt, in diesem Fall nämlich 2⁵.

Damit zeigt dieses Ausführungsbeispiel die Unterteilung des Signals PWM in den einzelnen Speicherplätzen entsprechende Zeitunterblöcke und die zeitliche Umordnung der Zeitunterblöcke durch die Bit-Vertauschung der Speicheradressen. Im Gegensatz zum vorherigen Ausführungsbeispiel liegt hier also zunächst ein konventionelles PWM-Signal vor.

## Patentansprüche

1. Verfahren zur Digital-Analog-Wandlung,
bei dem aus einem digitalen Signal (C) ein verschachteltes pulsweitenmoduliertes Signal (VPWM) erzeugt wird und
das verschachtelte pulsweitenmodulierte Signal (VPWM) mit einem Filter mit Tiefpasscharakteristik gefiltert wird,
wobei das verschachtelte pulsweitenmodulierte Signal (VPWM) bei zumindest einem Teil der Werte des digitalen Signals (C) innerhalb einer Musterwiederholzeit (T) zumindest zwei Zeitunterblöcke mit einem bestimmten logischen Zustand und zumindest zwei weitere Zeitunterblöcke mit einem anderen bestimmten logischen Zustand enthält und
die Summe der Pulsweiten der Zeitunterblöcke den digitalen Wert (C) darstellt.

2. Verfahren nach Anspruch 1, bei dem das digitale Signal ein pulsweitenmoduliertes Signal ist und
das verschachtelte pulsweitenmodulierte Signal aus dem pulsweitenmodulierten Signal erzeugt wird, indem innerhalb einer Musterwiederholzeit des pulsweitenmodulierten Signals ein Zeitblock mit einem bestimmten logischen Zustand zeitlich in eine Mehrzahl von Zeitunterblöcken unterteilt wird und
diese Zeitunterblöcke in solcher Weise umgeordnet werden, dass die Anzahl von logischen Zustandswechseln innerhalb der Musterwiederholzeit erhöht wird.

3. Verfahren nach Anspruch 2, bei dem die Anzahl der logischen Zustandswechsel innerhalb der Musterwiederholzeit (T) maximiert wird.

4. Verfahren nach Anspruch 2 oder 3, bei dem zumindest in der Hälfte der Musterwiederholzeit (T) eine jeweilige Gleichverteilung von Zeitunterblöcken mit bestimmtem logischen Zustand erzielt wird.

5. Verfahren nach Anspruch 1, bei dem das verschachtelte pulsweitenmodulierte Signal (VPWM) durch Vergleich der jeweiligen Signalwerte (C) des digitalen Signals (C) mit einem Signal erzeugt (VZ) wird, welches durch Bitvertauschung aus einem digitalen Zählersignal (Z) erzeugt wird.

6. Verfahren nach Anspruch 5, bei dem das digitale Zählersignal (Z) so bitvertauscht wird, dass das am wenigsten signifikante Bit an die Stelle des am meisten signifikanten Bits gesetzt wird.

7. Verfahren nach Anspruch 6, bei dem die Bitreihenfolge invertiert wird.

8. Verfahren nach Anspruch 5, 6 oder 7, bei dem zur Bitvertauschung eine Look-Up-Tabelle verwendet wird.

9. Schaltung zur Durchführung des Verfahrens nach einem der vorstehenden Ansprüche mit
einer Einrichtung (µC) zum Erzeugen des verschachtelten pulsweitenmodulierten Signals (VPWM) aus dem digitalen Signal (C) und
einem Tiefpassfilter zum Filtern des verschachtelten pulsweitenmodulierten Signals (VPWM).

10. Schaltung nach Anspruch 9, bei dem die Tiefpassfilterung mit einem RC-Filter zweiter Ordnung erfolgt.

11. Schaltung nach Anspruch 9 oder 10, die dazu ausgelegt ist, ein Verfahren nach einem der Ansprüche 2 - 8 auszuführen.

12. Elektronisches Vorschaltgerät für eine Licht emittierende Vorrichtung, insbesondere eine Lampe oder LED, mit einer Schaltung nach Anspruch 9, 10 oder 11.

13. Elektronisches Vorschaltgerät nach Anspruch 12 mit einer Mikrocontroller-Steuerung (µC), wobei ein Digitalsignal (C) der Mikrocontroller-Steuerung (µC) an die Einrichtung zum Erzeugen des verschachtelten pulsweitenmodulierten Signals angeschlossen ist.
